**Europäisches Patentamt**

**European Patent Office**

**Office européen des brevets**

(19)

(11) Veröffentlichungsnummer: **0 025 953**
**B1**

## EUROPÄISCHE PATENTSCHRIFT

(12)

(45) Veröffentlichungstag der Patentschrift:
27.07.83

(51) Int. Cl.³: **H 01 R 23/70, H 05 K 7/14**

(21) Anmeldenummer: **80105473.5**

(22) Anmeldetag: **12.09.80**

(54) Kontaktfeder für eine niederohmige Masseverbindung einer Leiterplatte mit einem geerdeten Baugruppenträger.

(30) Priorität: **25.09.79 DE 2938760**

(43) Veröffentlichungstag der Anmeldung:
**01.04.81 Patentblatt 81/13**

(45) Bekanntmachung des Hinweises auf die Patenterteilung:
**27.07.83 Patentblatt 83/30**

(84) Benannte Vertragsstaaten:
**CH DE FR GB LI NL**

(56) Entgegenhaltungen:
**DE-A-2 554 106**
**DE-A-2 711 085**
**FR-A-1 528 669**
**FR-A-2 094 220**
**FR-A-2 114 207**
**GB-A-1 238 879**
**US-A-3 184 650**
**US-A-3 689 865**
**US-A-3 950 057**

(73) Patentinhaber: **SIEMENS AKTIENGESELLSCHAFT,
Berlin und München Wittelsbacherplatz 2,
D-8000 München 2 (DE)**

(72) Erfinder: **Lechner, Ernst-Friedrich, Bissinger Strasse 31,
D-8520 Erlangen (DE)**
Erfinder: **Meusel, Otto, Aufsessstrasse 18,
D-8520 Erlangen (DE)**
Erfinder: **Eisenreich, Günter, Eskilstunastrasse 21,
D-8520 Erlangen (DE)**

Kontaktfeder für eine niederohmige Masseverbindung einer Leiterplatte mit
einem geerdeten Baugruppenträger

Die Erfindung bezieht sich auf eine Kontaktfeder für eine niederohmige Masseverbindung einer mit elektronischen Bauelementen bestückten, in wenigstens einer Führungsleiste aus isolierendem Werkstoff, insbesondere Kunststoff, aufgenommenen Leiterplatte mit einem Baugruppenträger, der eine gut leitende Oberfläche aufweist und mit einem Bezugspotential verbunden ist.

Bei einer bekannten Einrichtung (DE-A-2 653 216) zum Potentialausgleich in elektronischen Aufbausystemen wird ein Potentialpunkt an einer Baugruppe über eine Kontaktfeder mit einem entsprechenden Bezugspotentialpunkt am Baugruppenträger verbunden. Als Bezugspotentialpunkt ist eine mit dem als abschirmendes Gehäuse ausgebildeten Baugruppenträger verbundene Kontaktbahn vorgesehen, die als Kupferschiene oder als elektrisch gut leitende Oberflächenschicht ausgeführt ist. Die Kontaktfeder wird durch ein an der Baugruppe befestigtes Kunststoffteil gehalten.

Der Erfindung liegt die Aufgabe zugrunde, eine einfacher zu handhabende Kontaktfeder zu schaffen, die eine sichere Kontaktierung zwischen dem Potential der Leiterplatte und dem Baugruppenträger gewährleistet, der seinerseits mit dem Bezugspotential verbunden ist.

Diese Aufgabe wird erfindungsgemäß dadurch gelöst, daß die Kontaktfeder in einer entsprechenden Ausnehmung der Führungsleiste aufgenommen ist und einen den Rand der Leiterplatte U-förmig umfassenden Bereich mit federnden Zungen oder Vertiefungen aufweist, die an Leiterbahnen anliegen, die das Potential der Leiterplatte führen, und sowohl eine elektrisch gut leitende Verbindung zu diesen Leiterbahnen herstellen als auch die Kontaktfeder mechanisch auf der Leiterplatte halten, und daß die Kontaktfeder einen federnd ausgebildeten Schenkel aufweist, der durch eine Öffnung der Führungsleiste hindurchgreift und in eine entsprechende Vertiefung am Baugruppenträger einrastet oder den Baugruppenträger hintergreift.

Die erfindungsgemäße Kontaktfeder liegt federnd sowohl an den das Potential der Leiterplatte führenden Leiterbahnen als auch an der gut leitenden Oberfläche des geerdeten Baugruppenträgers an und stellt eine sichere elektrisch leitende Verbindung zwischen beiden her. Die Handhabung bei der Montage ist denkbar einfach. Die erfindungsgemäße Kontaktfeder wird in die entsprechende Ausnehmung der Führungsleiste eingelegt, wobei ihr Schenkel durch die entsprechende Öffnung der Führungsleiste hindurchgreift. Die Leiterplatte wird jetzt in den U-förmigen Bereich der Kontaktfeder eingeschoben. Damit ist bereits eine sichere mechanische Verbindung zwischen der Leiterplatte und der Kontaktfeder hergestellt. Beim Einschieben in den Baugruppenträger rastet der Schenkel der Kontaktfeder in eine entsprechende Vertiefung des Baugruppenträgers ein oder hintergreift diesen. Damit wird sowohl die Führungsleiste am Baugruppenträger gehalten als auch der elektrische Kontakt zwischen den Leiterbahnen, die das Bezugspotential der Leiterplatte führen, und dem geerdeten Baugruppenträger hergestellt.

Ein Ausführungsbeispiel der Erfindung ist in den Zeichnungen dargestellt und wird im folgenden im einzelnen erläutert. Es zeigt

Fig. 1 eine Ansicht von vorne auf einen Baugruppenträger mit eingeschobener Leiterplatte, teilweise im Schnitt gemäß der Linie I-I der Fig. 2,

Fig. 2 einen Längsschnitt durch die Führungsleiste mit eingelegter Kontaktfeder gemäß der Linie II-II der Fig. 4,

Fig. 3 einen Querschnitt durch die Führungsleiste mit eingelegter Kontaktfeder und eingesetzter Leiterplatte gemäß der Linie III-III von Fig. 4,

Fig. 4 eine Schnittansicht von oben auf die Führungsleiste mit eingelegter Kontaktfeder und eingesetzter Leiterplatte gemäß der Linie IV-IV der Fig. 1.

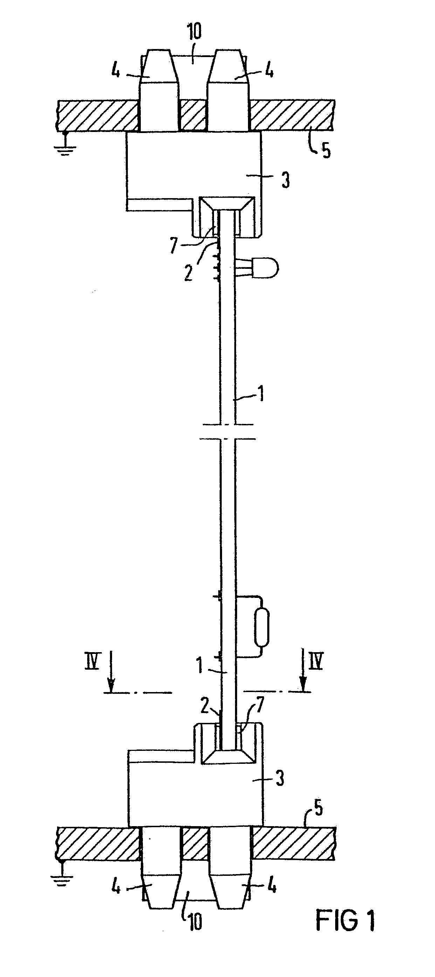

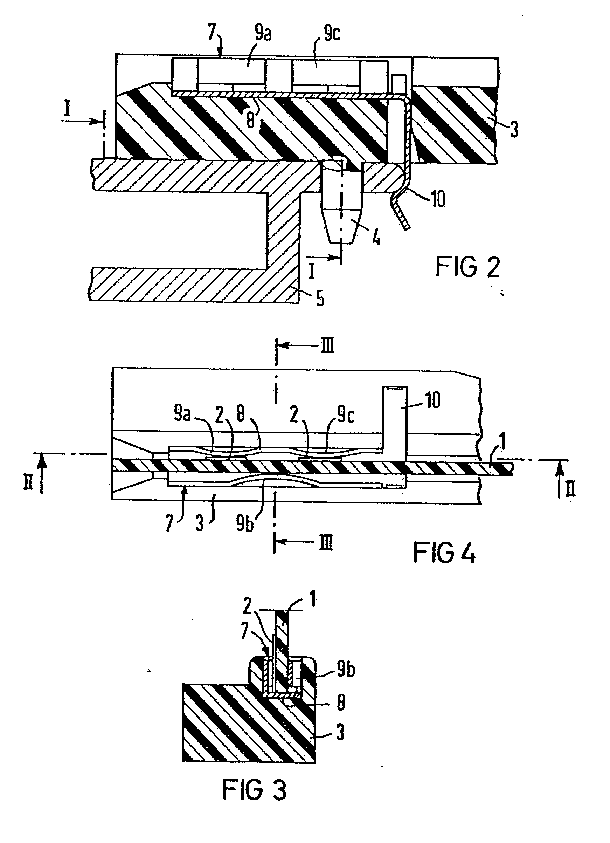

Die Fig. 1 zeigt eine Leiterplatte 1, auf der schematisch einige nicht näher bezeichnete elektronische Bauelemente angeordnet sind. Die Leiterplatte 1 ist in Führungsleisten 3 aus isolierendem Werkstoff, insbesondere Kunststoff, aufgenommen. Die Führungsleisten 3 weisen entsprechende Schlitze zur Aufnahme der Leiterplatte auf. Die Führungsleisten 3 greifen mit Zapfen 4 in Bohrungen des Baugruppenträgers 5 ein. In einer entsprechend geformten Ausnehmung der Führungsleiste 3 ist jeweils eine Kontaktfeder 7 eingelegt. Die Ausbildung der Kontaktfeder ist am besten aus Fig. 2 und Fig. 4 ersichtlich, wobei in Fig. 2 die in die Kontaktfeder eingeschobene Leiterplatte nicht dargestellt ist. Die Kontaktfeder 7 weist einen Bereich 8 auf, der den Rand der Leiterplatte 1 U-förmig umfaßt. Der Bereich 8 hat mehrere federnd ausgebildete Vertiefungen 9a, 9b, 9c. Die federnden Vertiefungen halten die Kontaktfeder 7 mechanisch auf der Leiterplatte 1. Die federnden Vertiefungen 9a und 9c liegen an Leiterbahnen 2 an, die das Potential der Leiterplatte 1 führen. Hierdurch wird eine elektrisch gut leitende Verbindung zwischen der Kontaktfeder 7 und diesen Leiterbahnen hergestellt. Die Kontaktfeder 7 weist außerdem einen federnd ausgebildeten Schenkel 10 auf, der durch eine Öffnung der Führungsleiste 3 hindurchgreift und den Baugruppenträger 5 hintergreift. Der Baugruppenträger 5 ist geerdet und weist zumindest an den Stellen, an denen der Schenkel 10 der Kontaktfeder 7 einrastet, eine gut leitende Oberfläche auf. Hierzu kann der Baugruppenträger 5 beispielsweise verzinnt sein. Hierdurch entsteht eine elektrisch gut leitende Verbindung zwischen der Kontaktfeder 7 und dem geerdeten Baugruppenträger 5. Insgesamt ergibt sich somit auf einfache Weise eine niederohmige Masseverbindung zwischen den Leiterbahnen 2, die das Potential der Leiterplatte 1 führen, und dem geerdeten Baugruppenträger 5 über die Kontaktfeder 7, die einerseits mit den federnden Vertiefungen 9a und 9c an den potentialführenden Leiterbahnen 2 und andererseits mit dem federnden Schenkel 10 am Baugruppenträger 5 unter Vorspannung anliegt. Der Schenkel 10 der Kontaktfeder 7 stellt nicht nur eine niederohmige Masseverbindung zum Baugruppenträger 5 her, sondern sichert auch die Führungsleiste 3 mit der Kontaktfeder 7 auf dem Baugruppenträger.

**Patentanspruch**

Kontaktfeder (7) für eine niederohmige Masseverbindung einer mit elektronischen Bauelementen bestückten, in wenigstens einer Führungsleiste (3) aus isolierendem Werkstoff, insbesondere Kunststoff, aufgenommenen Leiterplatte (1) mit einem Baugruppenträger (5), der eine elektrisch gut leitende Oberfläche aufweist und mit einem Bezugspotential verbunden ist, dadurch gekennzeichnet, daß die Kontaktfeder (7) in einer entsprechenden Ausnehmung der Führungsleiste (3) aufgenommen ist und einen den Rand der Leiterplatte (1) U-förmig umfassenden Bereich (8) mit federnden Zungen oder Vertiefungen (9) aufweist, die an Leiterbahnen (2) anliegen, die das Potential der Leiterplatte (1) führen, und sowohl eine elektrisch gut leitende Verbindung zu diesen Leiterbahnen herstellen als auch die Kontaktfeder mechanisch auf der Leiterplatte halten, und daß die Kontaktfeder (7) einen federnd ausgebildeten Schenkel (10) aufweist, der durch eine Öffnung der Führungsleiste (3) hindurchgreift und in eine entsprechende Vertiefung am Baugruppenträger einrastet oder den Baugruppenträger (5) hintergreift.

**Claim**

1. A contact spring (7) for a low-resistance mass connection of a circuit board (1) which is provided with electronic components, is accommodated in at least one guide strip (3) made of insulating material, in particular synthetic resin, and has an assembly carrier (5) which has a highly electrically conductive surface and is connected to a reference potential, characterised in that the contact spring (7) is housed in a corresponding recess in the guide strip (3) and has an areal portion (8) which surrounds the edge of the circuit board (1) in U-shaped fashion and has resilient tongues or indentations (9) which rest against conductor paths (2), which carry the potential of the circuit board (1) and which tongues or indentations both establish a highly electrically conductive connection to these conductor paths and also mechanically hold the contact spring on the circuit board; and that the contact spring (7) has a resilient arm (10) which projects through an opening in the guide strip (3) and engages into a corresponding recess on the assembly carrier, or engages behind the assembly carrier (5).

**Revendication**

Ressort de contact (7) pour la mise à la masse avec une faible résistance ohmique d'une plaquette de circuits imprimés qui est équipée de composants électroniques et qui est reçue dans au moins une réglette de guidage (3) en matériau isolant, notamment en matière synthétique, avec un support de sous-ensembles (5) qui possède une surface bonne conductrice du point de vue électrique et qui est relié à un potentiel de référence, caractérisé par le fait que le ressort de contact (7) est reçu dans un évidement correspondant de la réglette de guidace (3) et comporte une zone (8) qui entoure le bord de la plaquette de circuits imprimés (1) à la manière d'un U et qui comporte des languettes ou creux élastiques (9) qui s'appuient sur des voies conductrices (2) qui se trouvent au potentiel de la plaquette de circuits imprimés, et qui établissent une bonne liaison conductrice du point de vue électrique avec ces voies conductrices et maintiennent également mécaniquement le ressort de contact sur la plaquette de circuits imprimés, et que le ressort de contact (7) comporte une brache (10) de constitution élastique qui traverse une ouverture de la réglette de guidage (3) et s'engage dans un creux correspondant sur le support de sous-ensembles ou passe derrière le support de sous-ensembles (5).

FIG 1

FIG 2

FIG 4

FIG 3